# EUROPÄISCHE PATENTSCHRIFT

(11) **EP 1 964 457 B1**
(45) Veröffentlichungstag und Bekanntmachung des Hinweises auf die Patenterteilung: **22.04.2009**
(21) Anmeldenummer: 06818416.7
(22) Anmeldetag: 08.11.2006
(51) Int. Cl.: H05K 9/00

(54) **GEHÄUSE ZUR ABSCHIRMUNG VON ELEKTROMAGNETISCHEN STÖRUNGEN**
HOUSING FOR SCREENING FROM ELECTROMAGNETIC INTERFERENCES
BOÎTIER DE PROTECTION CONTRE LES PERTURBATIONS ÉLECTROMAGNÉTIQUES

(30) Priorität: 21.12.2005 DE 102005061336
(43) Veröffentlichungstag der Anmeldung: 03.09.2008
(73) Patentinhaber: Rohde & Schwarz GmbH & Co. KG, 81675 München (DE)
(72) Erfinder: MEIER, Josef, 80636 München (DE)
(74) Vertreter: Körfer, Thomas
(86) Internationale Anmeldenummer: PCT/EP2006/010702
(87) Internationale Veröffentlichungsnummer: WO 2007/079808

(56) Entgegenhaltungen:
- WO-A2-02/47452
- DE-A1- 3 638 123
- US-A- 5 545 844
- US-A1- 2004 069 515

## Beschreibung

Die vorliegende Erfindung bezieht sich auf ein Gehäuse zur Abschirmung von elektromagnetischen Störungen.

Aus der DE 36 38 123 A1 ist eine Vorrichtung zur Abschirmung elektronischer Geräte zu Prüfzwecken gegen feldgebundene elektromagnetische Störungen bekannt. Die Vorrichtung besteht aus einer flexiblen, in ihrer Form dem zu prüfenden Gerät anpassbaren, für elektromagnetische Störungen undurchdringlichen, allseitig geschlossenen Hülle aus einem leitfähigen Material, wobei dieses vorzugsweise ein metallisiertes Textilgewebe ist. Dabei weist die allseitig geschlossene Hülle einen Reisverschluss oder einen textilen Klettverschluss auf.

Des weiteren ist in der Praxis ein zweiteiliges Gehäuse üblich, dessen erstes Gehäuseteil und zweites Gehäuseteil mit einer großen Anzahl von Schraubverbindungen aneinander fixiert sind. Der Nachteil dabei besteht in der Aufwendigkeit der Vielzahl von Schraubverbindungen, die zwar mechanisch stabil sind, aber aufwendig zu fertigen und anzubringen sind. Ein weiterer Nachteil ist, dass ein solches Gehäuse nicht absolut elektromagnetisch dicht ist, da zwischen den einzelnen Schraubverbindungen Schlitze vorhanden sind, die für die elektromagnetische Strahlung durchlässig sind.

US 5 545 844 A offenbart ein Gehäuse zur Abschirmung von elektrischen Störungen, umfassend ein erstes Gehäuseteil mit einem Klettverschlusselement und ein zweites Gehäuseteil mit einem zweiten Klettverschlusselement aus jeweils leitfähigem Material, wobei ein Schlitz zwischen dem ersten Gehäuseteil und dem zweiten Gehäuseteil durch Ausbildung eines Klettverschlusses elektromagnetisch dicht abgeschlossen ist.

Der Erfindung liegt daher die Aufgabe zu Grunde, ein Gehäuse zuschaffen, dessen Gehäuseteile zerstörungsfrei und leicht lösbar sind, wobei die Verbindung der Gehäuseteile elektromagnetisch absolut dicht ist.

Diese Aufgabe wird erfindungsgemäß durch das in Anspruch 1 beschriebene Gehäuse gelöst.

Anspruch 1 beschreibt ein Gehäuse zur Abschirmung von elektromagnetischen Störungen. Das erfindungsgemäße Gehäuse besteht aus einem ersten Gehäuseteil mit einem ersten Klettverschlusselement und einem zweiten Gehäuseteil mit einem zweiten Klettverschlusselement aus jeweils leitfähigen Material, wobei ein Schlitz zwischen dem ersten Gehäuseteil und dem zweiten Gehäuseteil mittels eines aus leitfähigen Material gefertigten dritten Klettverschlusselements elektromagnetisch dicht abgeschlossen ist.

Ein Vorteil des erfindungsgemäßen Gehäuses liegt darin, dass bei einem Aufeinanderlegen der beiden Gehäuseteile der durch Fertigungstoleranzen entstehende Schlitz zwischen den beiden Gehäuseteilen elektromagnetisch dicht abgeschlossen ist, so dass innerhalb des erfindungsgemäßen Gehäuses eine gute elektromagnetische Abschirmung im Bezug auf die Umgebung des erfindungsgemäßen Gehäuses gewährleistet ist.

Vorteilhafte Weiterbildungen der Erfindung sind in den Unteransprüchen angegeben.

Ein weiterer Vorteil des erfindungsgemäßen Gehäuses ist, dass sowohl das Material des ersten und zweiten Gehäuseteils als auch der Klettverschlusselemente aus Metall sein können, so dass das erfindungsgemäße Gehäuse elektromagnetisch dicht abgeschlossen ist. Eine alternative vorteilhafte Weiterbildung des erfindungsgemäßen Gehäuses besteht darin, dass die Klettverschlusselemente aus leitfähigen Kunststoff gefertigt sind.

Weiter ist es von Vorteil, dass sich die beiden Gehäuseteile leicht und zerstörungsfrei von einander lösen lassen.

Ein Ausführungsbeispiel der Erfindung wird nachfolgend unter Bezugnahme auf die Zeichnung näher beschrieben. In der Zeichnung zeigt:

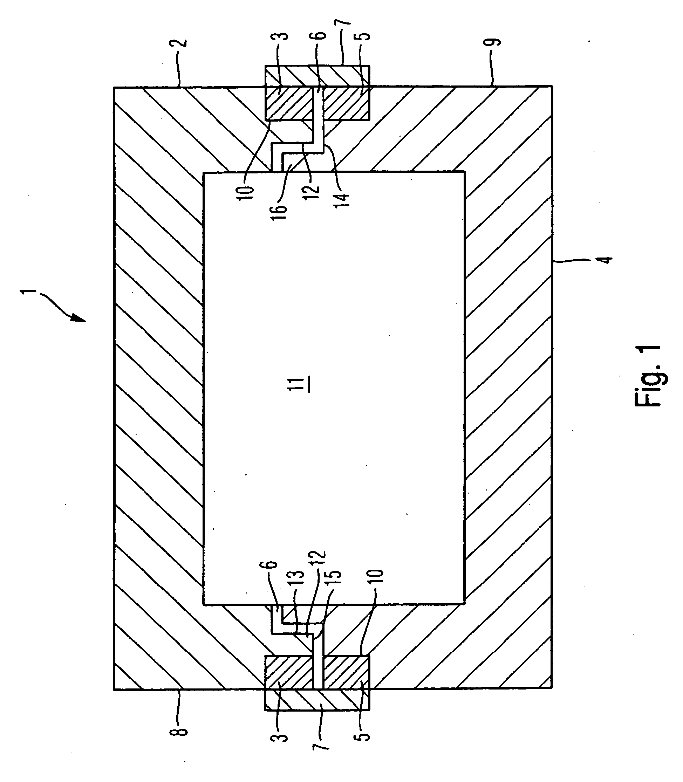

- Fig. 1: eine Schnitt durch ein erfindungsgemäßes Gehäuse mit drei Klettverschlusselementen.

Fig. 1 zeigt einen Schnitt durch ein erfindungsgemäßes Gehäuse 1 mit drei Klettverschlusselementen 3, 5, 7. Das erfindungsgemäße Gehäuse 1 zur Abschirmung von elektromagnetischen Störungen besteht aus einem ersten Gehäuseteil 2 mit einem ersten Klettverschlusselement 3 und einem zweiten Gehäuseteil 4 mit einem zweiten Klettverschlusselement 5. Erstes und zweites Klettverschlusselement 3, 5 sind jeweils aus leitfähigen Material insbesondere aus Metall oder einem elektrisch leitfähigen Kunststoff gefertigt. Aufgrund von Fertigungstoleranzen ist bei einem Aufeinanderlegen der beiden Gehäuseteile 2, 4 ein Schlitz 6 ausgebildet, der für elektromagnetische Strahlung durchlässig ist. Dieser Schlitz 6 ist mittels eines dritten aus leitfähigen Material gefertigten Klettverschlusselements 7 elektromagnetisch dicht abgeschlossen, wodurch eine gute Abschirmung des Gehäuse-Inneren 11 bezüglich einer Umgebung des erfindungsgemäßen Gehäuses 1 gewährleistet ist.

Das leitfähige Material der drei Klettverschlusselemente 3, 5, 7 ist entweder ein Metall oder ein leitfähiger Kunststoff.

Seitenwände 8, 9 des ersten und zweiten Gehäuseteils 2, 4 können jeweils eine metallische Schicht mit einer vergrößerten Oberfläche aufweisen, die einer Haftschicht eines Klettverschlusselements 3, 5 entsprechen, wobei die metallische Schicht mit der vergrößerten Oberfläche auf die Seitenwände 8, 9 des ersten und zweiten Gehäuseteils 2, 4 aufgedampft sein kann.

Das dritte Klettverschlusselement 7 ist als Verbindung des ersten Klettverschlusselements 3 mit dem zweiten Klettverschlusselement 5 vorgesehen und umgibt die Kontaktstelle 12 zwischen dem ersten und dem zweiten Gehäuseteil 2, 4. Das dritte Klettverschlusselement 7 ist daher als Gegenelement komplementär zu dem ersten und zweiten Klettverschlusselement 3, 5 ausgebildet. Es hat z. B. Haken, wenn das erste und zweite Klettverschlusselement einen Filz hat und umgekehrt.

An einem äußeren Ende einer Seitenwand 8, 9 des ersten Gehäuseteils 2 und des zweiten Gehäuseteils 3 ist im Ausführungsbeispiel jeweils eine umlaufende Nut 10 vorgesehen. Das erfindungsgemäße Gehäuse 1 wird dadurch geschlossen, dass das erste Gehäuseteil 2 auf das zweite Gehäuseteil 4 gelegt wird.

Die Seitenwand 8, 9 des ersten und zweiten Gehäuseteils 3, 4 weist an ihrer Oberseite im Ausführungsbeispiel jeweils eine umlaufende Ausnehmung 13, 14 auf, wobei diese Ausnehmungen 13, 14 komplementär zueinander ausgeprägt sind. Wird das erste Gehäuseteil 2 auf das zweite Gehäuseteil 4 gelegt, so fügt sich eine Nase 16 des zweiten Gehäuseteils 4 in die Ausnehmung 13 des ersten Gehäuseteils 2, so dass das erste Gehäuseteil 2 stabil und gegen Verrutschen gesichert auf dem zweiten Gehäuseteil 4 zum Aufliegen kommt. Eine Nase 15 des ersten Gehäuseteils 2 fügt sich in die Ausnehmung 14 des zweiten Gehäuseteils 4, so dass beide Gehäuseteile 2, 4 dicht aneinander liegen.

In die umlaufende Nut 10 der beiden Gehäuseteile ist jeweils ein Klettverschlusselement 3, 5 eingelegt, wobei die Breite des Klettverschlusselements 3, 5 der Breite der Nut 10 entspricht und somit in dieser festgeklemmt ist. Die Klemmverschlusselemente 3, 5 können in die umlaufende Nut 10 des ersten und zweiten Gehäuseteils 2, 4 eingeklebt, eingeklemmt, eingelegt oder mit dieser verschweißt sein.

Das dritte Klettverschlusselement 7 ist so über die in die Nuten 10 eingelegten, eingeklebten, verklemmten oder verschweißten Klettverschlusselemente 3, 5 gelegt, dass ein Schlitz 6 an der Kontaktstelle 12 zwischen dem ersten und dem zweiten Gehäuseteil 2, 4 elektromagnetisch abgedichtet ist, wobei das Klettverschlusselement 3, 5, 7 bevorzugt ein umlaufendes Klettverschlussband ist.

Die Erfindung ist nicht auf das dargestellte Ausführungsbeispiel bzw. die beschriebenen Ausführungsbeispiele beschränkt und kann z.B. auch dazu benutzt werden zwei Gehäuse gleichzeitig miteinander stabil und reversibel bzw. zerstörungsfrei ohne großen Aufwand zu verbinden.

## Patentansprüche

1. Gehäuse (1) zur Abschirmung von elektromagnetischen Störungen, umfassend ein erstes Gehäuseteil (2) mit einem ersten Klettverschlusselement (3) und ein zweites Gehäuseteil (4) mit einem zweiten Klettverschlusselement (5) aus jeweils leitfähigem Material, wobei ein Schlitz (6) zwischen dem ersten Gehäuseteil (2) und dem zweiten Gehäuseteil (4) mittels eines aus leitfähigem Material bestehenden dritten Klettverschlusselements (7), das mit dem ersten Klettverschlusselement (3) und dem zweiten Klettverschlusselement (5) zur Ausbildung eines Klettverschlusses zusammenwirkt, elektromagnetisch dicht abgeschlossen ist.

2. Gehäuse nach Anspruch 1,
**dadurch gekennzeichnet,**
**dass** das leitfähige Material der Klettverschlusselemente (3, 5, 7) ein Metall ist.

3. Gehäuse nach Anspruch 1 oder 2,
**dadurch gekennzeichnet,**
**dass** Seitenwände (8, 9) des ersten und zweiten Gehäuseteils (2, 4) jeweils eine metallische Schicht mit einer vergrößerten Oberfläche aufweisen, die einer Haftschicht eines Klettverschlusselements (3, 5) entsprechen.

4. Gehäuse nach Anspruch 3,
**dadurch gekennzeichnet,**
**dass** die metallische Schicht mit einer vergrößerten Oberfläche auf die Seitenwände (8, 9) des ersten und zweiten Gehäuseteils (2, 4) aufgedampft ist.

5. Gehäuse nach einem der Ansprüche 1 bis 3,
**dadurch gekennzeichnet,**
**dass** das dritte Klettverschlusselement (7) als Verbindung des ersten Klettverschlusselements (3) mit dem zweiten Klettverschlusselement (5) vorgesehen ist.

6. Gehäuse nach einem der Ansprüche 1 bis 5,
**dadurch gekennzeichnet,**
**dass** jeweils eine umlaufende Nut (10) an einem äußeren Ende einer Seitenwand (8, 9) des ersten Gehäuseteils (2) und des zweiten Gehäuseteils (4) vorgesehen ist.

7. Gehäuse nach Anspruch 6,
**dadurch gekennzeichnet,**
**dass** in die umlaufende Nut (10) des ersten und des zweiten Gehäuseteils (2, 4) jeweils ein Klettverschlusselement (3, 5) eingelegt ist.

8. Gehäuse nach Anspruch 6,
**dadurch gekennzeichnet,**
**dass** in der umlaufenden Nut (10) des ersten und des zweiten Gehäuseteils (2, 4) jeweils ein Klettverschlusselement (3, 5) mittels Klemmwirkung fixiert ist.

9. Gehäuse nach Anspruch 6,
**dadurch gekennzeichnet,**
**dass** in der umlaufenden Nut (10) des ersten und des zweiten Gehäuseteils (2, 4) jeweils ein Klettverschlusselement (3, 5) eingeklebt ist.

10. Gehäuse nach Anspruch 6,
**dadurch gekennzeichnet,**
**dass** in der umlaufenden Nut (10) des ersten und des zweiten Gehäuseteils (2, 4) jeweils ein Klettverschlusselement (3, 5) verschweißt ist.

11. Gehäuse nach einem der Ansprüche 1 bis 10,
**dadurch gekennzeichnet,**
**dass** das dritte Klettverschlusselement (7) so über die in die Nuten (10) eingelegten bzw. fixierten Klettverschlusselemente (3, 5) gelegt ist, dass ein Schlitz (6) an einer Kontaktstelle (12) zwischen dem ersten und dem zweiten Gehäuseteil (2, 4) elektromagnetisch abgedichtet ist.

12. Gehäuse nach einem der Ansprüche 1 bis 11,
**dadurch gekennzeichnet,**
**dass** jedes Klettverschlusselement (3, 5, 7) ein Klettverschlussband ist.

13. Gehäuse nach Anspruch 1,
**dadurch gekennzeichnet,**
**dass** das leitfähige Material der Klettverschlusselemente (3, 5, 7) ein leitfähiger Kunststoff ist.

## Claims

1. Housing (1) for shielding from electromagnetic interference, comprising a first housing component (2) with a first velcro-type fastening element (3) and a second housing component (4) with a second velcro-type fastening element (5) each made of conductive material, wherein an aperture (6) between the first housing component (2) and the second housing component (4) is closed in an electromagnetically-sealing manner by means of a third velcro-type fastening element (7) made of conductive material, which cooperates with the first velcro-type fastening element (3) and the second velcro-type fastening element (5) to form a velcro-type fastening.

2. Housing according to claim 1,
**characterised in that**
the conductive material of the velcro-type fastening elements (3, 5, 7) is a metal.

3. Housing according to claim 1 or 2,
**characterised in that**
lateral walls (8, 9) of the first and second housing component (2, 4) each provide a metallic layer with an enlarged surface area, which correspond with an adhesive layer of a velcro-type fastening element (3, 5).

4. Housing according to claim 3,
**characterised in that**
the metallic layer with an enlarged surface area is applied to the lateral walls (8, 9) of the first and second housing component (2, 4) by vapour deposition.

5. Housing according to any one of claims 1 to 3,
**characterised in that**
the third velcro-type fastening element (7) is provided as a connection between the first velcro-type fastening element (3) and the second velcro-type fastening element (5).

6. Housing according to any one of claims 1 to 5,
**characterised in that**
a peripheral groove (10) is provided respectively at an external end of a lateral wall (8, 9) of the first housing component (2) and of the second housing component (4).

7. Housing according to claim 6,
**characterised in that**
the velcro-type fastening element (3, 5) is inserted respectively into the peripheral groove (10) of the first and the second housing component (2, 4).

8. Housing according to claim 6,
**characterised in that**
the velcro-type fastening element (3, 5) is attached respectively in the peripheral groove (10) of the first and the second housing component (2, 4) by means of a clamping effect.

9. Housing according to claim 6,
**characterised in that**
the velcro-type fastening element (3, 5) is glued respectively into the peripheral groove (10) of the first and the second housing component (2, 4).

10. Housing according to claim 6,
**characterised in that**
the velcro-type fastening element (3, 5) is welded respectively into the peripheral groove (10) of the first and second housing component (2, 4).

11. Housing according to any one of claims 1 to 10, **characterised in that**
the third velcro-type fastening element (7) is attached over the velcro-type fastening elements (3, 5) inserted or respectively fitted into the grooves (10) in such a manner that an aperture (6) at a point of contact (12) between the first and second housing component (2, 4) is closed in an electromagnetically-sealing manner.

12. Housing according to any one of claims 1 to 11,
**characterised in that**
each velcro-type fastening element (3, 5, 7) is a velcro-type fastening tape.

13. Housing according to claim 1,
**characterised in that**
the conductive material of the velcro-type fastening elements (3, 5, 7) is a conductive synthetic material.

## Revendications

1. Boîtier (1) de protection contre les perturbations électromagnétiques, comportant une première partie de boîtier (2) avec un premier élément de fermeture Velcro (3) et une seconde partie de boîtier (4) avec un deuxième élément de fermeture Velcro (5) en un matériau conducteur respectivement, dans lequel une fente (6) entre la première partie de boîtier (2) et la seconde partie de boîtier (4) est fermée de manière étanche électromagnétiquement au moyen d'un troisième élément de fermeture Velcro (7) se composant du matériau conducteur, qui coopère avec le premier élément de fermeture Velcro (3) et le deuxième élément de fermeture Velcro (5) pour la réalisation d'une fermeture Velcro.

2. Boîtier selon la revendication 1,
**caractérisé en ce**
**que** le matériau conducteur des éléments de fermeture Velcro (3, 5, 7) est un métal.

3. Boîtier selon la revendication 1 ou 2,
**caractérisé en ce**
**que** les parois latérales (8, 9) de la première et seconde parties de boîtier (2, 4) présentent respectivement une couche métallique avec une surface agrandie, lesquelles correspondent à une couche adhésive d'un élément de fermeture Velcro (3, 5).

4. Boîtier selon la revendication 3,
**caractérisé en ce**
**que** la couche métallique avec une surface agrandie est métallisée sous vide sur les parois latérales (8, 9) de la première et seconde parties de boîtier (2, 4).

5. Boîtier selon l'une quelconque des revendications 1 à 3,
**caractérisé en ce**
**que** le troisième élément de fermeture Velcro (7) est prévu pour servir de liaison entre le premier élément de fermeture Velcro (3) et le deuxième élément de fermeture Velcro (5).

6. Boîtier selon l'une quelconque des revendications 1 à 5,
**caractérisé en ce**
**que** respectivement une rainure (10) périphérique est prévue sur une extrémité extérieure d'une paroi latérale (8, 9) de la première partie de boîtier (2) et de la seconde partie de boîtier (4).

7. Boîtier selon la revendication 6,
**caractérisé en ce**
**que** dans la rainure périphérique (10) de la première et seconde parties de boîtier (2, 4) est inséré respectivement un élément de fermeture Velcro (3, 5).

8. Boîtier selon la revendication 6,
**caractérisé en ce**
**que** dans la rainure périphérique (10) de la première et seconde parties de boîtier (2, 4) est fixé respectivement un élément de fermeture Velcro (3, 5) par coincement.

9. Boîtier selon la revendication 6,
**caractérisé en ce**
**que** dans la rainure périphérique (10) de la première et seconde parties de boîtier (2, 4) est collé respectivement un élément de fermeture Velcro (3, 5).

10. Boîtier selon la revendication 6,
**caractérisé en ce**
**que** dans la rainure périphérique (10) de la première et seconde parties de boîtier (2, 4) est soudé respectivement un élément de fermeture Velcro (3, 5).

11. Boîtier selon l'une quelconque des revendications 1 à 10,
**caractérisé en ce**
**que** le troisième élément de fermeture Velcro (7) est placé au-dessus des éléments de fermeture Velcro (3, 5) fixés ou insérés dans les rainures (10) de sorte qu'une fente (6) soit rendue étanche électromagnétiquement sur un point de contact (12) entre la première et la seconde parties de boîtier (2, 4).

12. Boîtier selon l'une quelconque des revendications 1 à 11,
**caractérisé en ce**
**que** chaque élément de fermeture Velcro (3, 5, 7) est une bande de fermeture Velcro.

13. Boîtier selon la revendication 1,
**caractérisé en ce**
**que** le matériau conducteur des éléments de fermeture Velcro (3, 5, 7) est une matière plastique conductrice.
